# EUROPEAN PATENT APPLICATION

(11) **EP 4 290 551 A1**
(43) Date of publication of application: **13.12.2023**
(21) Application number: 21969553.3
(22) Date of filing: 30.12.2021

(54) **PEROVSKITE CELL, PREPARATION METHOD THEREFOR, AND PHOTOVOLTAIC MODULE COMPRISING SAME**

(71) Applicant: Contemporary Amperex Technology Co., Limited, Ningde, Fujian 352100 (CN)
(72) Inventor: TU, Bao, Ningde, Fujian 352100 (CN); CHEN, Changsong, Ningde, Fujian 352100 (CN); GUO, Yongsheng, Ningde, Fujian 352100 (CN); CHEN, Guodong, Ningde, Fujian 352100 (CN)
(74) Representative: Jacob, Reuben Ellis
(86) International application number: PCT/CN2021/142996
(87) International publication number: WO 2023/123190

(57) **Abstract**

The present application provides a perovskite cell, a preparation method therefor, and a photovoltaic module comprising same. The perovskite cell comprises: a first electrode, a second electrode, a perovskite layer located therebetween, an organic hole transport layer located between the first electrode and the perovskite layer, and an inorganic hole transport layer located between the organic hole transport layer and the perovskite layer, wherein the thickness H₁ of the inorganic hole transport layer and the thickness H₂ of the organic hole transport layer satisfy H₁/H₂≤0.4, and the inorganic hole transport layer comprises an inorganic hole transport material which is selected from inorganic P-type semiconductor materials having a room temperature solubility of less than 0.10 mg/mL in N,N-dimethylformamide. The present application may solve the problem of poor interfacial wettability of an organic hole transport layer and a perovskite layer, and increase the preparation success rate and the photoelectric conversion efficiency of the perovskite cell.

## Description

### TECHNICAL FIELD

This application relates to the technical field of solar batteries, and in particular, to a perovskite battery, a method for preparing same, and a photovoltaic module containing same.

### BACKGROUND

With the development of modern industry, the problems global energy shortage and environmental pollution are increasingly prominent, and solar batteries as an ideal renewable energy source have attracted more and more attention. A solar cell, also known as a photovoltaic cell, is a device that converts optical energy directly into electrical energy through a photoelectric effect or photochemical effect. A perovskite battery is a new type of solar cell that is being researched extensively currently. In a few years since its inception, the perovskite battery has soon achieved a relatively high optical-to-electrical conversion efficiency that is up to more than 25%, and enjoys a good application prospect. As an important part of a perovskite battery, a hole transport material is of great significance in improving the optical-to-electrical conversion efficiency and stability of the battery. Compared with an inorganic hole transport material, an organic hole transport material can conveniently adjust the energy level structure through molecular design, and therefore, is more flexible and more widely applicable in perovskite batteries. However, the relatively high hydrophobicity of organic hole transport materials leads to poor effect of infiltration at an interface between the organic hole transport layer and the perovskite layer, thereby bringing great difficulties to the batch manufacture of perovskite batteries.

### SUMMARY

An objective of this application is to provide a perovskite battery, a method for preparing same, and a photovoltaic module containing same. This application alleviates the problem of poor infiltration at an interface between an organic hole transport layer and a perovskite layer, and improves a yield rate and an optical-to-electrical conversion efficiency of the perovskite battery.

A first aspect of this application provides a perovskite battery. The perovskite battery includes: a first electrode; a second electrode; a perovskite layer, located between the first electrode and the second electrode; an organic hole transport layer, located between the first electrode and the perovskite layer; and an inorganic hole transport layer, located between the organic hole transport layer and the perovskite layer. A thickness H₁ of the inorganic hole transport layer and a thickness H₂ of the organic hole transport layer satisfy H₁/H₂ ≤ 0.4. The inorganic hole transport layer includes an inorganic hole transport material. The inorganic hole transport material is selected from inorganic P-type semiconductor materials that are soluble in N,N-dimethylformamide under a room temperature at a solubility lower than 0.10 mg/mL.

During the research, the applicant finds that, the inorganic hole transport layer disposed between the organic hole transport layer and the perovskite layer significantly improves the effect of infiltration at an interface between the organic hole transport layer and the perovskite layer, increases a coating area of a perovskite precursor solution, reduces occurrences of battery short-circuits caused by an insufficient coating area, and therefore, improves the yield rate of the perovskite battery. In addition, a reasonable setting of the ratio of the thickness of the inorganic hole transport layer to the thickness of the organic hole transport layer not only avoids an adverse effect on the performance of the perovskite battery, but also enhances the performance of the perovskite battery to some extent, for example, increases an open circuit voltage, a value of a fill factor, an optical-to-electrical conversion efficiency, and the like.

In any embodiment of this application, 0.1 ≤ H₁/H₂ ≤ 0.4.

In any embodiment of this application, the thickness H₁ of the inorganic hole transport layer is less than or equal to 10 nm. Optionally, 2 nm ≤ H₁ ≤ 8 nm. When falling within an appropriate range, the thickness of the inorganic hole transport layer significantly improves the effect of infiltration at the interface between the organic hole transport layer and the perovskite layer, increases the coating area of the perovskite precursor solution, reduces occurrences of battery short-circuits caused by an insufficient coating area, improves the yield rate of the perovskite battery, and at the same time, enhances the performance of the perovskite battery, for example, increases the open circuit voltage, the fill factor value, the optical-to-electrical conversion efficiency, and the like.

In any embodiment of this application, the thickness H₂ of the organic hole transport layer is 10 nm to 30 nm. When the thickness of the organic hole transport layer falls within an appropriate range, the organic hole transport layer can maintain relatively high capabilities of hole extraction and transport, and can ensure proper transport of hole carriers even if an inorganic hole transport layer is added, thereby avoiding an adverse effect on the performance of the perovskite battery.

In any embodiment of this application, the thickness satisfies H₁ + H₂ ≤ 30 nm.

In any embodiment of this application, the thickness H₁ of the inorganic hole transport layer, the thickness H₂ of the organic hole transport layer, and a thickness H₃ of the perovskite layer satisfy (H₁ + H₂)/H₃ ≤ 1/20. Optionally, 1/50 ≤ (H₁ + H₂)/H₃ ≤ 1/20.

In any embodiment of this application, the inorganic P-type semiconductor materials include at least one of a material represented by a structural formula MNₓ or a material obtained by doping same. In the structural formula, M is at least one of Cu, Ni, Mo, Co, Cr, Sn, Mn, W, or V; N is at least one of O, S, SCN, F, Cl, Br, or I; and 0 < x ≤ 3. Optionally, M is at least one of Cu, Ni, or Mo; and optionally, N is at least one of O, SCN, or I.

Optionally, the inorganic P-type semiconductor materials are at least one selected from nickel oxide, molybdenum oxide, cuprous iodide, cuprous oxide, cuprous thiocyanate, and a material obtained by doping any one thereof. Such inorganic P-type semiconductor materials ensure matching of an energy level between the inorganic hole transport layer and the perovskite layer, thereby facilitating the extraction and transport of hole carriers and achieving higher performance of the perovskite battery.

In any embodiment of this application, a conduction band minimum of an inorganic P-type semiconductor material is greater than or equal to -3.9 eV, and a valence band maximum falls between -5.4 eV and -5.1 eV In this way, the energy level is well matched between the inorganic hole transport layer and the perovskite layer according to this application, thereby facilitating the extraction and transport of hole carriers and achieving higher performance of the perovskite battery.

In any embodiment of this application, the organic hole transport layer includes an organic hole transport material. The organic hole transport material is at least one selected from poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazole-spirobifluorene, poly(3,4-ethylenedioxythiophene):polystyrene sulfonic acid, polythiophene, a derivative of any one thereof, and a material obtained by doping any one thereof.

In any embodiment of this application, the perovskite layer includes a perovskite material. Optionally, the perovskite material is at least one selected from an inorganic halide perovskite material, an organic halide perovskite material, and an organic-inorganic hybrid halide perovskite material.

In any embodiment of this application, a material of the first electrode includes a transparent metal conductive oxide. Optionally, the transparent metal conductive oxide includes at least one of fluorine-doped tin oxide (FTO), indium-doped tin oxide (ITO), aluminum-doped zinc oxide (AZO), boron-doped zinc oxide (BZO), or indium-doped zinc oxide (IZO).

In any embodiment of this application, a material of the second electrode includes at least one of carbon, gold, silver, aluminum, copper, fluorine-doped tin oxide (FTO), indium-doped tin oxide (ITO), aluminum-doped zinc oxide (AZO), boron-doped zinc oxide (BZO), or indium-doped zinc oxide (IZO).

In any embodiment of this application, the perovskite battery further includes an electron transport layer located between the perovskite layer and the second electrode.

A second aspect of this application provides a method for preparing a perovskite battery. The method includes at least steps of: forming an organic hole transport layer on a first electrode, forming an inorganic hole transport layer on the organic hole transport layer, and forming a perovskite layer on the inorganic hole transport layer. A thickness H₁ of the inorganic hole transport layer and a thickness H₂ of the organic hole transport layer satisfy H₁/H₂ ≤ 0.4. The inorganic hole transport layer includes an inorganic hole transport material. The inorganic hole transport material is selected from inorganic P-type semiconductor materials that are soluble in N,N-dimethylformamide under a room temperature at a solubility lower than 0.10 mg/mL.

During the research, the applicant finds that, the inorganic hole transport layer disposed between the organic hole transport layer and the perovskite layer significantly improves the effect of infiltration at an interface between the organic hole transport layer and the perovskite layer, increases a coating area of a perovskite precursor solution, reduces occurrences of battery short-circuits caused by an insufficient coating area, and therefore, improves the yield rate of the perovskite battery. When the thickness H₁ of the inorganic hole transport layer and the thickness H₂ of the organic hole transport layer satisfy H₁/H₂ ≤ 0.4, the setting improves the efficiency of extracting and transporting the hole carriers at the interface, and reduces the recombination of electrons and holes at the interface, thereby enhancing the performance of the perovskite battery, for example, increasing the open circuit voltage, the fill factor value, and the optical-to-electrical conversion efficiency.

In any embodiment of this application, 0.1 ≤ H₁/H₂ ≤ 0.4.

In any embodiment of this application, the thickness H₁ of the inorganic hole transport layer is less than or equal to 10 nm. Optionally, 2 nm ≤ H₁ ≤ 8 nm. When falling within an appropriate range, the thickness of the inorganic hole transport layer significantly improves the effect of infiltration at the interface between the organic hole transport layer and the perovskite layer, increases the coating area of the perovskite precursor solution, reduces occurrences of battery short-circuits caused by an insufficient coating area, improves the yield rate of the perovskite battery, and at the same time, enhances the performance of the perovskite battery, for example, increases the open circuit voltage, the fill factor value, the optical-to-electrical conversion efficiency, and the like.

In any embodiment of this application, the thickness H₂ of the organic hole transport layer is 10 nm to 30 nm. When the thickness of the organic hole transport layer falls within an appropriate range, the organic hole transport layer can maintain relatively high capabilities of hole extraction and transport, and can ensure proper transport of hole carriers even if an inorganic hole transport layer is added, thereby avoiding an adverse effect on the performance of the perovskite battery.

In any embodiment of this application, the thickness satisfies H₁ + H₂ ≤ 30 nm.

In any embodiment of this application, the thickness H₁ of the inorganic hole transport layer, the thickness H₂ of the organic hole transport layer, and a thickness H₃ of the perovskite layer satisfy (H₁ + H₂)/H₃ ≤ 1/20. Optionally, 1/50 ≤ (H₁ + H₂)/H₃ ≤ 1/20.

In any embodiment of this application, the inorganic P-type semiconductor materials include at least one of a material represented by a structural formula MNₓ or a material obtained by doping same. In the structural formula, M is at least one of Cu, Ni, Mo, Co, Cr, Sn, Mn, W, or V; N is at least one of O, S, SCN, F, Cl, Br, or I; and 0 < x ≤ 3. Optionally, M is at least one of Cu, Ni, or Mo; and optionally, N is at least one of O, SCN, or I.

Optionally, the inorganic P-type semiconductor materials are at least one selected from nickel oxide, molybdenum oxide, cuprous iodide, cuprous oxide, cuprous thiocyanate, and a material obtained by doping any one thereof. Such inorganic P-type semiconductor materials ensure matching of an energy level between the inorganic hole transport layer and the perovskite layer, thereby facilitating the extraction and transport of hole carriers and achieving higher performance of the perovskite battery.

In any embodiment of this application, a conduction band minimum of an inorganic P-type semiconductor material is greater than or equal to -3.9 eV, and a valence band maximum falls between -5.4 eV and -5.1 eV In this way, the energy level is well matched between the inorganic hole transport layer and the perovskite layer according to this application, thereby facilitating the extraction and transport of hole carriers and achieving higher performance of the perovskite battery.

A third aspect of this application provides a photovoltaic module. The photovoltaic module includes the perovskite battery according to the first aspect of this application or a perovskite battery prepared by the method according to the second aspect of this application.

The photovoltaic module according to this application includes the perovskite battery according to this application, and therefore, has at least the same advantages as the perovskite battery.

### BRIEF DESCRIPTION OF DRAWINGS

To describe the technical solutions of the embodiments of this application more clearly, the following outlines the drawings to be used in the embodiments of this application. Evidently, the drawings outlined below are merely a part of embodiments of this application. A person of ordinary skill in the art may derive other drawings from such drawings without making any creative efforts.
FIG. 1 is a schematic structural diagram of a perovskite battery according to an embodiment of this application;
FIG. 2 shows a coating result of a perovskite precursor solution in Embodiments 1 to 5 and Comparative Embodiments 1 to 3; and
FIG. 3 shows test results of perovskite batteries prepared in Embodiments 1 to 5 and Comparative Embodiments 1 to 3 under a solar irradiation standard spectrum.

### DETAILED DESCRIPTION OF EMBODIMENTS

The following describes and discloses in detail a perovskite battery, a method for preparing same, and a photovoltaic module containing same according to this application with due reference to drawings. However, unnecessary details may be omitted in some cases. For example, a detailed description of a well-known matter or repeated description of an essentially identical structure may be omitted. That is intended to prevent the following descriptions from becoming unnecessarily lengthy, and to facilitate understanding by a person skilled in the art. In addition, the drawings and the following descriptions are intended for a person skilled in the art to thoroughly understand this application, but not intended to limit the subject-matter set forth in the claims.

A "range" disclosed herein is defined in the form of a lower limit and an upper limit. A given range is defined by a lower limit and an upper limit selected. The selected lower and upper limits define the boundaries of a particular range. A range so defined may be inclusive or exclusive of the end values, and a lower limit of one range may be arbitrarily combined with an upper limit of another range to form a range. For example, if a given parameter falls within a range of 60 to 120 and a range of 80 to 110, it is expectable that the parameter may fall within a range of 60 to 110 and a range of 80 to 120 as well. In addition, if lower-limit values 1 and 2 are listed, and if upper-limit values 3, 4, and 5 are listed, the following ranges are all expectable: 1 to 3, 1 to 4, 1 to 5, 2 to 3, 2 to 4, and 2 to 5. Unless otherwise specified herein, a numerical range "a to b" is a brief representation of a combination of any real numbers between a and b inclusive, where both a and b are real numbers. For example, a numerical range "0 to 5" herein means all real numbers recited between 0 and 5 inclusive, and the expression "0 to 5" is just a brief representation of a combination of such numbers. In addition, a statement that a parameter is an integer greater than or equal to 2 is equivalent to a disclosure that the parameter is an integer such as 2, 3, 4, 5, 6, 7, 8, 9, 10, 11, 12, and so on.

Unless otherwise expressly specified herein, all embodiments and optional embodiments hereof may be combined with each other to form a new technical solution considered to be included in the content disclosed in this application.

Unless otherwise expressly specified herein, all technical features and optional technical features hereof may be combined with each other to form a new technical solution considered to be included in the content disclosed in this application.

Unless otherwise expressly specified herein, all steps described herein may be performed in sequence or at random, and preferably in sequence. For example, that the method includes steps (a) and (b) indicates that the method may include steps (a) and (b) performed in sequence, or steps (b) and (a) performed in sequence. For example, that the method may further include step (c) indicates that step (c) may be added into the method in any order. For example, the method may include steps (a), (b), and (c), or may include steps (a), (c), and (b), or may include steps (c), (a), and (b), and so on.

Unless otherwise expressly specified herein, "include" and "comprise" mentioned herein mean open-ended inclusion, or closed-ended inclusion. For example, the terms "include" and "comprise" may mean inclusion of other items that are not recited, or inclusion of only the items recited.

Unless otherwise expressly specified herein, the term "or" is inclusive. For example, the expression "A or B" means "A alone, B alone, or both A and B". More specifically, any one of the following conditions satisfies the condition "A or B" : A is true (or existent) and B is false (or absent); A is false (or absent) and B is true (or existent); and, both A and B are true (or existent).

The working principles of a perovskite battery are: under illumination conditions, a photon with energy higher than a band gap of a light absorbing layer is absorbed by a light absorbing material in the light absorbing layer, thereby causing excitation of a valence band electron in this layer into a conduction band and leaving a hole in the valence band; when the conduction band energy level of the light absorbing layer is higher than the conduction band energy level of the electron transport layer, the conduction band electron in the light absorbing layer will be injected into the conduction band of the electron transport layer, and then transported to an anode and an external circuit; and, when the valence band energy level of the light absorbing layer is lower than the valence band energy level of the hole transport layer, the hole in the light absorbing layer is injected into the hole transport layer, and then transported to a cathode and an external circuit, thereby forming a complete circuit. Generally, a perovskite battery is prepared layer by layer from bottom to top. Perovskite batteries are classed into a regular (n-i-p structure) configuration and an inverted (p-i-n structure) configuration depending on the capability of a perovskite underlying material to extract electrons or holes in the perovskite. With respect to the regular configuration, a preparation process is usually to prepare an electron transport layer, a perovskite layer, a hole transport layer, and an anode metal layer sequentially on a transparent cathode. With respect to the inverted configuration, a preparation process is usually to prepare a hole transport layer, a perovskite layer, an electron transport layer, and a cathode metal layer sequentially on a transparent anode.

The hole transport material is an important part of the perovskite battery and constrains the performance of the perovskite battery. Currently, the hole transport materials currently used in the perovskite batteries are mainly classed into an inorganic hole transport material and an organic hole transport material. The inorganic hole transport material offers a narrow choice, and demands a stringent preparation process. Therefore, the organic hole transport material is highlighted by research currently. Compared with an inorganic hole transport material, an organic hole transport material can conveniently adjust the energy level structure through molecular design, and therefore, is more flexible and enjoys a prospect of wider application in perovskite batteries.

Compared with the regular configuration, the battery device of an inverted configuration has many advantages, such as a simpler preparation process, a film formable at a low temperature, no obvious hysteresis effect, suitableness for the preparation of stacked devices, and the like. However, the battery device of an inverted configuration has some significant disadvantages, such as poor infiltration at the interface between the organic hole transport layer and the perovskite layer, and difficulty of fully coating the surface of the organic hole transport layer with the perovskite precursor solution, thereby resulting in a relatively low yield rate of the perovskite batteries and vulnerability to a short circuit of the battery devices.

Therefore, effective technical means are needed to improve the infiltration at the interface between the organic hole transport layer and the perovskite layer.

### Perovskite Battery

A first aspect of this application provides a perovskite battery.

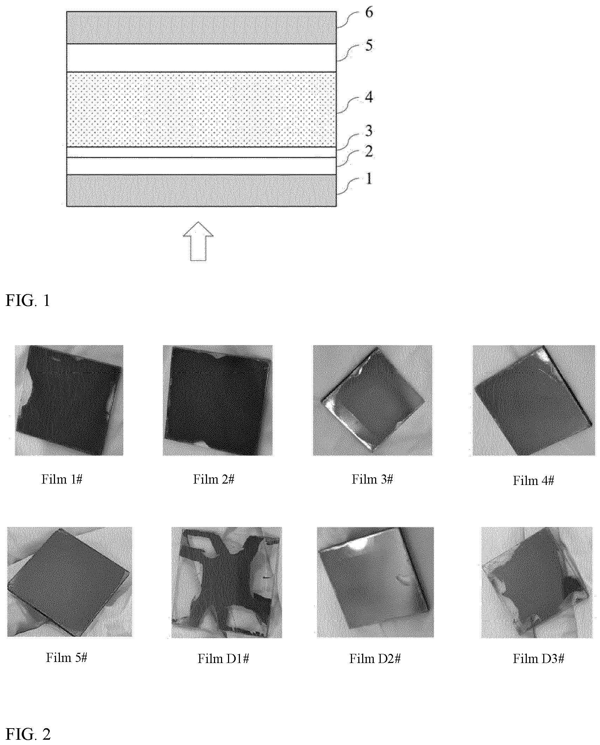

FIG. 1 is a schematic structural diagram of a perovskite battery according to an embodiment of this application, in which an arrow indicates an incident direction of light. As shown in FIG. 1, the perovskite battery includes: a first electrode 1; a second electrode 6; a perovskite layer 4, located between the first electrode 1 and the second electrode 6; an organic hole transport layer 2, located between the first electrode 1 and the perovskite layer 4; and an inorganic hole transport layer 3, located between the organic hole transport layer 2 and the perovskite layer 4. A thickness H₁ of the inorganic hole transport layer 3 and a thickness H₂ of the organic hole transport layer 2 satisfy H₁/H₂ ≤ 0.4. The inorganic hole transport layer 3 includes an inorganic hole transport material. The inorganic hole transport material is selected from inorganic P-type semiconductor materials that are soluble in N,N-dimethylformamide under a room temperature (that is, 25 °C) at a solubility lower than 0.10 mg/mL. In some embodiments, the first electrode 1 is a front electrode, and the second electrode 6 is a back electrode.

During the research, the applicant finds that, the inorganic hole transport layer disposed between the organic hole transport layer and the perovskite layer significantly improves the effect of infiltration at an interface between the organic hole transport layer and the perovskite layer, increases a coating area of a perovskite precursor solution, reduces occurrences of battery short-circuits caused by an insufficient coating area, and therefore, improves the yield rate of the perovskite battery. In addition, a reasonable setting of the ratio of the thickness of the inorganic hole transport layer to the thickness of the organic hole transport layer not only avoids an adverse effect on the performance of the perovskite battery, but also enhances the performance of the perovskite battery to some extent, for example, increases an open circuit voltage, a value of a fill factor, an optical-to-electrical conversion efficiency, and the like.

During the research, the applicant also finds that the ratio of the thickness of the inorganic hole transport layer to the thickness of the organic hole transport layer affects the performance of the perovskite battery. When the ratio of the thickness of the inorganic hole transport layer to the thickness of the organic hole transport layer is unduly high, an adverse effect will be caused to the performance of the perovskite battery. For example, the short-circuit current and the fill factor value of the perovskite battery may decline significantly. A possible reason is that the hole extraction capability of the inorganic hole transport material is lower than that of the organic hole transport material. Therefore, when the ratio of the thickness of the inorganic hole transport layer to the thickness of the organic hole transport layer is unduly high, the organic hole transport material may be obstructed from extracting hole carriers, thereby impairing the hole extraction capability of the organic hole transport material, and in turn, resulting in a decrease in the efficiency of extracting the hole carriers and severe recombination of carriers at the interface. In addition, when the ratio of the thickness of the inorganic hole transport layer to the thickness of the organic hole transport layer is unduly high, the size of perovskite grains grown on the inorganic hole transport layer is relatively small, and the crystallization degree of the perovskite grains is not high, resulting in a high density of bulk defect states of the grains, and in turn, impairing the performance of the perovskite battery.

After extensive research, the applicant finds that, when the thickness H₁ of the inorganic hole transport layer and the thickness H₂ of the organic hole transport layer satisfy H₁/H₂ ≤ 0.4, the setting significantly improves the infiltration at the interface between the organic hole transport layer and the perovskite layer, increases the coating area of the perovskite precursor solution, reduces occurrences of battery short-circuits caused by an insufficient coating area, and improves the yield rate of the perovskite batteries. In addition, when the thickness H₁ of the inorganic hole transport layer and the thickness H₂ of the organic hole transport layer satisfy H₁/H₂ ≤ 0.4, the setting improves the efficiency of extracting and transporting the hole carriers at the interface, and reduces the recombination of electrons and holes at the interface, thereby enhancing the performance of the perovskite battery, for example, increasing the open circuit voltage, the fill factor value, and the optical-to-electrical conversion efficiency. In some embodiments, 0.05 ≤ H₁/H₂ ≤ 0.4, 0.05 ≤ H₁/H₂ ≤ 0.35, 0.05 ≤ H₁/H₂ ≤ 0.3, 0.05 ≤ H₁/H₂ ≤ 0.25, 0.05 ≤ H₁/H₂ ≤ 0.2, 0.05 ≤ H₁/H₂ ≤ 0.15, 0.1 ≤ H₁/H₂ ≤ 0.4, 0.1 ≤ H₁/H₂ ≤ 0.35, 0.1 ≤ H₁/H₂ ≤ 0.3, 0.1 ≤ H₁/H₂ ≤ 0.25, 0.1 ≤ H₁/H₂ ≤ 0.2, or 0.1 ≤ H₁/H₂ < 0.15.

The solubility of the inorganic hole transport material in this application in N,N-dimethylformamide under a room temperature is less than 0.10 mg/mL, and therefore, will not dissolve in the perovskite precursor solution, thereby avoiding a decline in the crystallization quality of the perovskite grains and an increase in the density of bulk defect states, and the like.

After further research, the applicant finds that the thickness of the inorganic hole transport layer itself also affects the performance of the perovskite battery. When the inorganic hole transport layer is relatively thick, an adverse effect will be caused to the performance of the perovskite battery. For example, the short-circuit current and the fill factor value of the perovskite battery may decline. A possible reason is that, when the inorganic hole transport layer is relatively thick, the extraction of hole carriers will become mainly dependent on the inorganic hole transport layer. However, the hole extraction capability of the inorganic hole transport material is lower than that of the organic hole transport material. Consequently, the capability of the organic hole transport material to extract the hole carriers is not fully exerted, thereby reducing the efficiency of hole carrier extraction and severe recombination of carriers at the interface. In addition, when the inorganic hole transport layer is relatively thick, the size of perovskite grains grown on the inorganic hole transport layer is relatively small, and the crystallization degree of the perovskite grains is not high, resulting in a high density of bulk defect states of the grains, and in turn, impairing the performance of the perovskite battery.

After extensive research, the applicant finds that, when the thickness H₁ of the inorganic hole transport layer is less than or equal to 10 nm, the setting significantly improves the effect of infiltration at the interface between the organic hole transport layer and the perovskite layer, increases the coating area of the perovskite precursor solution, reduces occurrences of battery short-circuits caused by an insufficient coating area, improves the yield rate of the perovskite battery, and at the same time, enhances the performance of the perovskite battery, for example, increases the open circuit voltage, the fill factor value, the optical-to-electrical conversion efficiency, and the like. In some embodiments, the thickness H₁ of the inorganic hole transport layer may be less than or equal to 9 nm, 8 nm, 7 nm, 6 nm, 5 nm, 4 nm, 3 nm, or 2 nm.

To ensure a relatively large coating area of the perovskite precursor solution, the thickness H₁ of the inorganic hole transport layer needs to avoid being unduly small. In some embodiments, the thickness H₁ of the inorganic hole transport layer satisfies 0.5 nm ≤ H₁ ≤ 10 nm, 1 nm ≤ H₁ ≤ 10 nm, 2 nm ≤ H₁ ≤ 10 nm, 3 nm ≤ H₁ ≤ 10 nm, 4 nm ≤ H₁ ≤ 10 nm, 0.5 nm ≤ H₁ ≤ 8 nm, 1 nm ≤ H₁ ≤ 8 nm, 2 nm ≤ H₁ ≤ 8 nm, 3 nm ≤ H₁ ≤ 8 nm, 4 nm ≤ H₁ ≤ 8 nm, 0.5 nm ≤ H₁ ≤ 6 nm, 1 nm ≤ H₁ ≤ 6 nm, 2 nm ≤ H₁ ≤ 6 nm, 3 nm ≤ H₁ ≤ 6 nm, or 4 nm ≤ H₁ ≤ 6 nm.

The thickness H₂ of the organic hole transport layer falls within the same range as the thickness of the organic hole transport layer in a conventional perovskite battery. Therefore, the organic hole transport layer maintains relatively high capabilities of hole extraction and transport, and ensures proper transport of hole carriers even if an inorganic hole transport layer is added, thereby avoiding an adverse effect on the performance of the perovskite battery. In some embodiments, the thickness H₂ of the organic hole transport layer is 10 nm to 30 nm.

The organic hole transport layer and the inorganic hole transport layer as a whole serve as a hole transport layer of the perovskite battery, and are interposed between the first electrode and the perovskite layer. In some embodiments, an aggregate thickness of the hole transport layer may be less than or equal to 30 nm. That is, the sum of the thicknesses (H₁+H₂) of the organic hole transport layer and the inorganic hole transport layer is less than or equal to 30 nm.

Considering that the hole transport layer as a whole needs to satisfy a given sunlight transmittance to achieve a relatively high light absorptivity of the perovskite layer, the ratio of the aggregate thickness of the hole transport layer to the thickness of the perovskite layer needs to avoid being unduly high. In some embodiments, the thickness H₁ of the inorganic hole transport layer, the thickness H₂ of the organic hole transport layer, and the thickness H₃ of the perovskite layer satisfy (H₁ + H₂)/H₃ ≤ 1/20. Optionally, 1/50 ≤ (H₁ + H₂)/H₃ ≤ 1/20.

The thickness H₃ of the perovskite layer falls within the same range as the thickness of the perovskite layer in a conventional perovskite battery. In some embodiments, the thickness H₃ of the perovskite layer is 300 nm to 1000 nm.

In some embodiments, the inorganic P-type semiconductor materials include a material represented by a structural formula MNₓ, where M is at least one of Cu, Ni, Mo, Co, Cr, Sn, Mn, W, or V; N is at least one of O, S, SCN, F, Cl, Br, or I; and 0 < x ≤ 3. Optionally, M is at least one of Cu, Ni, or Mo; and optionally, N is at least one of O, SCN, or I.

Optionally, in some embodiments, the inorganic P-type semiconductor materials are at least one selected from nickel oxide (NiOₓ, 0 < x < 1), molybdenum oxide (MoOs), cuprous iodide (CuI), cuprous oxide (Cu₂O), and cuprous thiocyanate (CuSCN). Such inorganic P-type semiconductor materials ensure matching of an energy level between the inorganic hole transport layer and the perovskite layer, thereby facilitating the extraction and transport of hole carriers and achieving higher performance of the perovskite battery.

In some embodiments, the inorganic hole transport materials may be doped to adjust the energy band of the inorganic hole transport layer to a proper position, and make the inorganic hole transport layer and the perovskite layer exhibit an appropriate energy level gradient, thereby further improving the capabilities to extract and transport the hole carriers and reducing the recombination of electrons and holes at the interface. Optionally, the doping elements include at least one of an alkali metal element, an alkaline earth element, a transition metal element, a metal-poor element, a metalloid element, or a halogen element.

As an example, the alkali metal element includes at least one of Li, Na, K, Rb, or Cs. Optionally, the alkali metal element includes at least one of Li, Na, or K.

As an example, the alkaline earth element includes at least one of Be, Mg, Ca, Sr, or Ba. Optionally, the alkaline earth element includes at least one of Be, Mg, or Ca. Further optionally, the alkaline earth element includes Mg.

As an example, the transition metal element includes at least one of Ti, Cr, Mn, Fe, Co, Ni, Cu, Zn, Zr, Nb, Mo, Ru, Rh, Pd, Ag, Cd, Ta, Pt, or Au. Optionally, the transition metal element includes at least one of Ti, Cr, Mn, Fe, Co, Ni, Cu, or Mo. Further optionally, the transition metal element includes at least one of Co or Cu.

As an example, the metal-poor element includes at least one of Al, Ga, In, Sn, Tl, Pb, or Bi. Optionally, the metal-poor element includes at least one of Al or Ga. Further, the metal-poor element includes Al.

As an example, the metalloid element includes at least one of B, Si, Ge, As, Sb, or Te. Optionally, the metalloid element includes at least one of B or Sb. Further optionally, the metalloid element includes B.

As an example, the halogen element includes at least one of F, Cl, Br, or I. Optionally, the halogen element includes at least one ofF or Cl.

The morphology of the doping element is not particularly limited. For example, the doping element may be in the form of atoms, molecules, or ions. As an example, precursors used to form the doping element include, but are not limited to, at least one of simple-substance alkali metal, simple-substance alkaline earth, simple-substance transition metal, simple-substance poor metal, simple-substance metalloid, simple-substance halogen, alkali metal halide, alkaline earth halide, transition metal halide, metal-poor halide, or metalloid halide.

Optionally, in some embodiments, the inorganic hole transport material is at least one selected from nickel oxide (NiOₓ, 0 < x < 1), molybdenum oxide (MoOs), cuprous iodide (CuI), cuprous oxide (Cu₂O), cuprous thiocyanate (CuSCN), Cs-doped nickel oxide, Cu-doped nickel oxide, Cr-doped cuprous oxide, or Zr-doped cuprous oxide.

In some embodiments, a conduction band minimum (CBM) of an inorganic P-type semiconductor material is greater than or equal to -3.9 eV, and a valence band maximum (VBM) falls between -5.4 eV and -5.1 eV In this way, the energy level is well matched between the inorganic hole transport layer and the perovskite layer according to this application, thereby facilitating the extraction and transport of hole carriers and achieving higher performance of the perovskite battery. -

The organic hole transport layer includes an organic hole transport material. In some embodiments, the organic hole transport material is at least one selected from poly[bis(4-phenyl)(2,4,6-trimethylphenyl)amine] (PTAA), poly(3-hexylthiophene) (P3HT), triptycene-cored triphenylamine (H101), 3,4-ethylenedioxythiophene-methoxytriphenylamine (EDOT-OMeTPA), N-(4-aniline)carbazole-spirobifluorene (CzPAF-SBF), poly(3,4-ethylenedioxythiophene):polystyrene sulfonic acid (PEDOT:PSS), and polythiophene.

In some embodiments, the organic hole transport material may be doped to increase the concentration of holes of the organic hole transport layer, further improve the capabilities to extract and transport the hole carriers, and reduce the recombination of electrons and holes at the interface. The appropriately selected doping material also improves the electrical conductivity of the organic hole transport layer and the degree of energy level matching of the perovskite layer. Optionally, the doping material includes at least one of 2,3,5,6-tetrafluoro-7,7',8,8'-tetracyanodimethyl-p-benzoquinone (F4TCNQ), lithium bis(trifluoromethane)sulfonimide, or 4-tert-butyl-butylpyridine.

The perovskite layer includes a perovskite material. As an intrinsic semiconductor material, the perovskite material is capable of transporting both electrons and holes. Therefore, in a perovskite battery, the perovskite material is able to act not only as a perovskite layer, but also as an electron or hole transport layer. The type of the perovskite material is not particularly limited, and may be selected as actually required.

In some embodiments, the perovskite material may include at least one of an inorganic halide perovskite material, an organic halide perovskite material, or an organic-inorganic hybrid halide perovskite material. The molecular formula of the perovskite material may be ABX₃ or A₂CDX₆, where A represents an inorganic cation, an organic cation, or a hybrid organic-inorganic cation; B represents a divalent metal cation; C represents a monovalent metal cation; D represents a trivalent metal cation; and X represents a halogen ion.

As an example, A is at least one selected from CH₃NH₃⁺ (MA⁺ for short), CH(NH₂)₂⁺ (FA⁺), Li⁺, Na⁺, K⁺, Rb⁺, and Cs⁺. Optionally, A is at least one selected from CH₃NH₃⁺, CH(NH₂)₂⁺, and Cs⁺.

As an example, B is at least one selected from Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺. Optionally, B is one or two selected from Pb²⁺ and Sn²⁺.

As an example, C is at least one selected from Li⁺, Na⁺, K⁺, Rb⁺, Cs⁺, and Ag⁺.

As an example, D is at least one selected from In³⁺ and Bi³⁺.

As an example, X is at least one selected from F⁻, Cl⁻, Br⁻, and I⁻. Optionally, X is at least one selected from Cl⁻, Br⁻, and I⁻.

In some embodiments, the perovskite material includes, but is not limited to, at least one of CH₃NH₃PbI₃ (MAPbI₃ for short), CH(NH₂)₂PbI₃ (FAPbI₃ for short), Cs_{0.05}(FA_{0.83}MA_{0.17})_{0.95}Pb(I_{0.83}Br_{0.17})₃ (CsFAMA for short), CsPbI₃, CsPbI₂Br, CsPbIBr₂, Cs₂NaInCl₆, Cs₂KBiCl₆, or Cs₂AgInCl₆.

In some embodiments, the band gap of the perovskite layer may be 1.20 eV to 2.30 eV
In some embodiments, the material of the first electrode includes a transparent metal conductive oxide. Optionally, the transparent metal conductive oxide includes at least one of fluorine-doped tin oxide (FTO), indium-doped tin oxide (ITO), aluminum-doped zinc oxide (AZO), boron-doped zinc oxide (BZO), or indium-doped zinc oxide (IZO).

The thickness of the first electrode is not particularly limited, and may be selected as actually required. For example, in some embodiments, the thickness of the first electrode is 10 nm to 500 nm.

The material of the second electrode is not particularly limited, and may be selected as actually required. For example, the material of the second electrode is an organic conductive material, an inorganic conductive material, or a hybrid organic-inorganic conductive material. In some embodiments, the material of the second electrode includes at least one of carbon, gold, silver, aluminum, copper, fluorine-doped tin oxide (FTO), indium-doped tin oxide (ITO), aluminum-doped zinc oxide (AZO), boron-doped zinc oxide (BZO), or indium-doped zinc oxide (IZO).

The thickness of the second electrode is not particularly limited, and may be selected as actually required. For example, in some embodiments, the thickness of the second electrode is 10 nm to 500 nm.

As shown in FIG. 1, in some embodiments, the perovskite battery further includes an electron transport layer 5. The electron transport layer 5 is located between the perovskite layer 4 and the second electrode 6. The electron transport layer reduces a potential barrier between the second electrode and the perovskite layer, promotes the transport of electrons, effectively blocks holes, and reduces the recombination of electrons and holes at the interface.

The electron transport layer includes an electron transport material. The type of the electron transport material is not particularly limited, and may be selected as actually required. For example, the electron transport material is selected from an organic electron transport material, an inorganic electron transport material, or a hybrid organic-inorganic electron transport material.

As an example, the organic electron transport material includes at least one of fullerene or a derivative thereof. For example, the electron transport material includes at least one of [6,6]-phenyl C₆₁-methyl butyrate (PC₆₁BM), [6,6]-phenyl C₇₁-methyl butyrate (PC₇₁BM), fullerene C₆₀, or fullerene C₇₀. The conduction band minimum of fullerene and a derivative thereof well matches the conduction band minimum of the perovskite layer, thereby facilitating extraction and transport of electrons. The inorganic electron transport layer includes tin dioxide, titanium dioxide, and the like.

The thickness of the electron transport material is not particularly limited, and may be selected as actually required. For example, in some embodiments, the thickness of the electron transport layer is 20 nm to 300 nm.

The perovskite battery according to this application is not limited to the foregoing structures, and may include other functional layers. For example, the perovskite battery further includes an interface modification layer configured to modify each film layer. In some embodiments, the perovskite battery further includes an electrode modification layer that is configured to modify the first electrode to reduce an energy barrier between the perovskite layer and the first electrode, and serve functions of transporting holes and blocking electrons. In some embodiments, the perovskite battery further includes an electrode modification layer that is configured to modify the second electrode to reduce an energy barrier between the perovskite layer and the second electrode, and serve functions of transporting electrons and blocking holes. In some embodiments, the perovskite battery further includes an interface modification layer that is located between the electron transport layer and the perovskite layer and configured to reduce interface defects and reduce recombination of electrons and holes at the interface.

The perovskite battery according to the first aspect of this application may be used alone as a single-junction perovskite battery, or may be combined with a perovskite battery or another type of solar batterie to form a tandem battery, such as a perovskite-perovskite tandem battery, or a perovskite crystalline silicon tandem battery.

### Preparation Methods

A second aspect of this application provides a method for preparing a perovskite battery. The method includes at least steps of: forming an organic hole transport layer on a first electrode, forming an inorganic hole transport layer on the organic hole transport layer, and forming a perovskite layer on the inorganic hole transport layer. A thickness H₁ of the inorganic hole transport layer and a thickness H₂ of the organic hole transport layer satisfy H₁/H₂ ≤ 0.4. The inorganic hole transport layer includes an inorganic hole transport material. The inorganic hole transport material is selected from inorganic P-type semiconductor materials that are soluble in N,N-dimethylformamide under a room temperature at a solubility lower than 0.10 mg/mL. In some embodiments, the first electrode is a front electrode.

A general process of preparing a perovskite layer is to dissolve a perovskite precursor in a solvent to make a perovskite precursor solution, and then form a film layer by a solution processing method such as a scrape coating method, a spray coating method, or a spin coating method. The solvent configured to form the perovskite precursor solution includes, but is not limited to, N,N-dimethylformamide, dimethyl sulfoxide, and the like. A general process of preparing an organic hole transport layer is to dissolve an organic hole transport material in a hydrophobic solvent such as chlorobenzene, and then form a film layer by a solution processing method such as a scrape coating method, a spray coating method, or a spin coating method. During the research, the applicant unexpectedly finds that a reason for the poor infiltration at the interface between the organic hole transport layer and the perovskite layer is the approximate immiscibility between the solvent (such as chlorobenzene) used to dissolve the organic hole transport material and the solvent (such as N,N-dimethylformamide) used to dissolve the perovskite precursor. Consequently, the infiltration is poor at the interface between the organic hole transport layer and the perovskite layer, and, during preparation of the perovskite battery, the perovskite precursor solution can hardly fully coat the surface of the organic hole transport layer.

During the research, the applicant finds that, the inorganic hole transport layer disposed between the organic hole transport layer and the perovskite layer significantly improves the effect of infiltration at an interface between the organic hole transport layer and the perovskite layer, increases a coating area of a perovskite precursor solution, reduces occurrences of battery short-circuits caused by an insufficient coating area, and therefore, improves the yield rate of the perovskite battery. The method for preparing the inorganic hole transport layer according to this application is not particularly limited. In some embodiments, the method for preparing the inorganic hole transport layer may be a scrape coating method, a spray coating method, a spin coating method, a dip-coating method, a sputtering method, an evaporation deposition method, or the like.

During the research, the applicant also finds that the ratio of the thickness of the inorganic hole transport layer to the thickness of the organic hole transport layer affects the performance of the perovskite battery. When the ratio of the thickness of the inorganic hole transport layer to the thickness of the organic hole transport layer is unduly high, an adverse effect will be caused to the performance of the perovskite battery. For example, the short-circuit current and the fill factor value of the perovskite battery may decline significantly. A possible reason is that the hole extraction capability of the inorganic hole transport material is lower than that of the organic hole transport material. Therefore, when the ratio of the thickness of the inorganic hole transport layer to the thickness of the organic hole transport layer is unduly high, the organic hole transport material may be obstructed from extracting hole carriers, thereby impairing the hole extraction capability of the organic hole transport material, and in turn, resulting in a decrease in the efficiency of extracting the hole carriers and severe recombination of carriers at the interface. In addition, when the ratio of the thickness of the inorganic hole transport layer to the thickness of the organic hole transport layer is unduly high, the size of perovskite grains grown on the inorganic hole transport layer is relatively small, and the crystallization degree of the perovskite grains is not high, resulting in a high density of bulk defect states of the grains, and in turn, impairing the performance of the perovskite battery.

After extensive research, the applicant finds that, when the thickness H₁ of the inorganic hole transport layer and the thickness H₂ of the organic hole transport layer satisfy H₁/H₂ ≤ 0.4, the setting significantly improves the infiltration at the interface between the organic hole transport layer and the perovskite layer, increases the coating area of the perovskite precursor solution, reduces occurrences of battery short-circuits caused by an insufficient coating area, and improves the yield rate of the perovskite batteries. In addition, when the thickness H₁ of the inorganic hole transport layer and the thickness H₂ of the organic hole transport layer satisfy H₁/H₂ ≤ 0.4, the setting improves the efficiency of extracting and transporting the hole carriers at the interface, and reduces the recombination of electrons and holes at the interface, thereby enhancing the performance of the perovskite battery, for example, increasing the open circuit voltage, the fill factor value, and the optical-to-electrical conversion efficiency. In some embodiments, 0.05 ≤ H₁/H₂ ≤ 0.4, 0.05 ≤ H₁/H₂ ≤ 0.35, 0.05 ≤ H₁/H₂ ≤ 0.3, 0.05 ≤ H₁/H₂ ≤ 0.25, 0.05 ≤ H₁/H₂ ≤ 0.2, 0.05 ≤ H₁/H₂ ≤ 0.15, 0.1 ≤ H₁/H₂ ≤ 0.4, 0.1 ≤ H₁/H₂ ≤ 0.35, 0.1 ≤ H₁/H₂ ≤ 0.3, 0.1 ≤ H₁/H₂ ≤ 0.25, 0.1 ≤ H₁/H₂ ≤ 0.2, or 0.1 ≤ H₁/H₂ < 0.15.

The solubility of the inorganic hole transport material in this application in N,N-dimethylformamide under a room temperature is less than 0.10 mg/mL, and therefore, will not dissolve in the perovskite precursor solution, thereby avoiding a decline in the crystallization quality of the perovskite grains and an increase in the density of bulk defect states, and the like.

After further research, the applicant finds that the thickness of the inorganic hole transport layer itself also affects the performance of the perovskite battery. When the inorganic hole transport layer is relatively thick, an adverse effect will be caused to the performance of the perovskite battery. For example, the short-circuit current and the fill factor value of the perovskite battery may decline. A possible reason is that, when the inorganic hole transport layer is relatively thick, the extraction of hole carriers will become mainly dependent on the inorganic hole transport layer. However, the hole extraction capability of the inorganic hole transport material is lower than that of the organic hole transport material. Consequently, the capability of the organic hole transport material to extract the hole carriers is not fully exerted, thereby reducing the efficiency of hole carrier extraction and severe recombination of carriers at the interface. In addition, when the inorganic hole transport layer is relatively thick, the size of perovskite grains grown on the inorganic hole transport layer is relatively small, and the crystallization degree of the perovskite grains is not high, resulting in a high density of bulk defect states of the grains, and in turn, impairing the performance of the perovskite battery.

After extensive research, the applicant finds that, when the thickness H₁ of the inorganic hole transport layer is less than or equal to 10 nm, the setting significantly improves the effect of infiltration at the interface between the organic hole transport layer and the perovskite layer, increases the coating area of the perovskite precursor solution, reduces occurrences of battery short-circuits caused by an insufficient coating area, improves the yield rate of the perovskite battery, and at the same time, enhances the performance of the perovskite battery, for example, increases the open circuit voltage, the fill factor value, the optical-to-electrical conversion efficiency, and the like. In some embodiments, the thickness H₁ of the inorganic hole transport layer may be less than or equal to 9 nm, 8 nm, 7 nm, 6 nm, 5 nm, 4 nm, 3 nm, or 2 nm.

To ensure a relatively large coating area of the perovskite precursor solution, the thickness H₁ of the inorganic hole transport layer needs to avoid being unduly small. In some embodiments, the thickness H₁ of the inorganic hole transport layer satisfies 0.5 nm ≤ H₁ ≤ 10 nm, 1 nm ≤ H₁ ≤ 10 nm, 2 nm ≤ H₁ ≤ 10 nm, 3 nm ≤ H₁ ≤ 10 nm, 4 nm ≤ H₁ ≤ 10 nm, 0.5 nm ≤ H₁ ≤ 8 nm, 1 nm ≤ H₁ ≤ 8 nm, 2 nm ≤ H₁ ≤ 8 nm, 3 nm ≤ H₁ ≤ 8 nm, 4 nm ≤ H₁ ≤ 8 nm, 0.5 nm ≤ H₁ ≤ 6 nm, 1 nm ≤ H₁ ≤ 6 nm, 2 nm ≤ H₁ ≤ 6 nm, 3 nm ≤ H₁ ≤ 6 nm, or 4 nm ≤ H₁ ≤ 6 nm.

The thickness H₂ of the organic hole transport layer falls within the same range as the thickness of the organic hole transport layer in a conventional perovskite battery. Therefore, the organic hole transport layer maintains relatively high capabilities of hole extraction and transport, and ensures proper transport of hole carriers even if an inorganic hole transport layer is added, thereby avoiding an adverse effect on the performance of the perovskite battery. In some embodiments, the thickness H₂ of the organic hole transport layer is 10 nm to 30 nm.

The organic hole transport layer and the inorganic hole transport layer as a whole serve as a hole transport layer of the perovskite battery, and are interposed between the first electrode and the perovskite layer. In some embodiments, an aggregate thickness of the hole transport layer may be less than or equal to 30 nm. That is, the sum of the thicknesses (H₁+H₂) of the organic hole transport layer and the inorganic hole transport layer is less than or equal to 30 nm.

Considering that the hole transport layer as a whole needs to satisfy a given sunlight transmittance to achieve a relatively high light absorptivity of the perovskite layer, the ratio of the aggregate thickness of the hole transport layer to the thickness of the perovskite layer needs to avoid being unduly high. In some embodiments, the thickness H₁ of the inorganic hole transport layer, the thickness H₂ of the organic hole transport layer, and the thickness H₃ of the perovskite layer satisfy (H₁ + H₂)/H₃ ≤ 1/20. Optionally, 1/50 ≤ (H₁ + H₂)/H₃ ≤ 1/20.

The thickness H₃ of the perovskite layer falls within the same range as the thickness of the perovskite layer in a conventional perovskite battery. In some embodiments, the thickness H₃ of the perovskite layer is 300 nm to 1000 nm.

In some embodiments, the method for preparing a perovskite battery further includes steps of: forming an electron transport layer on the perovskite layer, and forming a second electrode on the electron transport layer. The second electrode may be a back electrode.

The preparation method according to the second aspect of this application can be used to prepare the perovskite battery according to the first aspect of this application. It is hereby noted that, for the relevant structure of the perovskite battery prepared by the foregoing preparation method, reference may be made to the description of the perovskite battery provided in each embodiment of the first aspect of this application.

### Photovoltaic Module

A third aspect of this application provides a photovoltaic module. The photovoltaic module includes the perovskite battery according to the first aspect of this application or a perovskite battery prepared by the method according to the second aspect of this application. The perovskite battery may be used as a power supply of the photovoltaic module after being subjected to other steps such as series-and-parallel connection and packaging.

In some embodiments, the photovoltaic module includes a battery prepared from the foregoing perovskite battery, for example, includes a single-junction perovskite battery, a perovskite-perovskite tandem cell, a perovskite crystalline silicon tandem cell, or the like.

### Embodiments

The following embodiments are more detailed descriptions of the subject-matter disclosed herein. The embodiments are merely intended as illustrative descriptions because, evidently, a person skilled in the art may make various modifications and changes to such embodiments without departing from what is disclosed herein. Unless otherwise specified, all fractions, percentages, and ratios mentioned in the following embodiments are values by weight. All reagents used in the embodiments are commercially available or can be synthesized according to conventional methods, and can be directly put into use without a need of further processing. All the instruments used in the embodiments are commercially available.

### Embodiment 1

Taking 20 ITO conductive glass sheets, each in a size of 2.0 cm × 2.0 cm. Laser-etching each of the glass sheets at 0.35 cm from the left and right ends of the sheet until 1 µm of the thickness is etched away so that the glass substrate is exposed. Subsequently, washing the surface of the glass sheet twice with acetone and isopropanol separately, and then immersing and sonicating the glass sheet in deionized water for 10 minutes. Drying the glass sheet by blowing nitrogen, and then cleaning the glass sheet in an ultraviolet ozone cleaner for 15 minutes.

Spin-coating the ITO conductive glass with a PTAA chlorobenzene solution at a speed of 5000 rpm, where the concentration of the solution is 2 mg/mL. Subsequently, heating the coating at 100 °C for 10 minutes on a constant-temperature hotplate to obtain an organic hole transport layer that is 20 nm thick.

Sputtering a 2-nm thick layer of nickel oxide NiOₓ nanoparticles onto the obtained organic hole transport layer. During the sputtering, the power of the radio frequency power supply is 1000 W, the pressure range of the cavity is 0.1 Pa to 0.5 Pa, the flow rate of argon and the flow rate of oxygen are both 200 sccm, the sputtering speed is 0.4 m/min, and the temperature in the whole sputtering process is not higher than 70 °C.

Spin-coating the obtained inorganic hole transport layer with an MAPbI₃ N,N-dimethylformamide solution at a speed of 1000 rpm to 5000 rpm, where the concentration of the solution is 1.5 mol/L. Subsequently, heating the coating at 100 °C for 30 minutes on a constant-temperature hotplate, and then cooling it down to a room temperature to obtain a perovskite film layer that is 680 nm thick, denoted as film 1#.

Spin-coating the obtained perovskite layer with a PC₆₁BM chlorobenzene solution at a speed of 1000 rpm to 1500 rpm, where the concentration of the solution is 20 mg/mL. Subsequently, heating the coating at 100 °C for 10 minutes on a constant-temperature hotplate, and then spin-coating the coating with bathocuproine (BCP) at a speed of 5000 rpm to form a passivation layer, where the thickness of the PC₆₁BM layer is 60 nm, and the thickness of the BCP passivation layer is 6 nm.

Making a specimen of the resultant product, putting the specimen into a vacuum coater, and evaporating and depositing a 100-nm thick Ag electrode on the surface of the obtained electron transport layer under a vacuum condition of 5×10⁻⁴ Pa.

The perovskite battery prepared in Embodiment 1 is denoted as battery 1#, with a structure of ITO/PTAA/NiOₓ/MAPbI₃/PC₆₁BM/BCP/Ag.

### Embodiment 2

The preparation method of the perovskite battery is similar to that in Embodiment 1 except that the thickness of the nickel oxide NiOₓ nanoparticles is 4 nm.

### Embodiment 3

The preparation method of the perovskite battery is similar to that in Embodiment 1 except that the thickness of the nickel oxide NiOₓ nanoparticles is 6 nm.

### Embodiment 4

The preparation method of the perovskite battery is similar to that in Embodiment 1 except that the thickness of the nickel oxide NiOₓ nanoparticles is 8 nm.

### Embodiment 5

The preparation method of the perovskite battery is similar to that in Embodiment 1 except that the thickness of the nickel oxide NiOₓ nanoparticles is 10 nm.

### Comparative Embodiment 1

Taking 20 ITO conductive glass sheets, each in a size of 2.0 cm × 2.0 cm. Laser-etching each of the glass sheets at 0.35 cm from the left and right ends of the sheet until 1 µm of the thickness is etched away so that the glass substrate is exposed. Subsequently, washing the surface of the glass sheet twice with acetone and isopropanol separately, and then immersing and sonicating the glass sheet in deionized water for 10 minutes. Drying the glass sheet by blowing nitrogen, and then cleaning the glass sheet in an ultraviolet ozone cleaner for 15 minutes.

Spin-coating the ITO conductive glass with a PTAA chlorobenzene solution at a speed of 5000 rpm, where the concentration of the solution is 2 mg/mL. Subsequently, heating the coating at 100 °C for 10 minutes on a constant-temperature hotplate to obtain an organic hole transport layer that is 20 nm thick.

Spin-coating the obtained organic hole transport layer with an MAPbI₃ N,N-dimethylformamide solution at a speed of 1000 rpm to 5000 rpm, where the concentration of the solution is 1.5 mol/L. Subsequently, heating the coating at 100 °C for 30 minutes on a constant-temperature hotplate, and then cooling it down to a room temperature to obtain a perovskite film layer that is 680 nm thick, denoted as film D1#.

Spin-coating the obtained perovskite layer with a PC₆₁BM chlorobenzene solution at a speed of 1000 rpm to 1500 rpm, where the concentration of the solution is 20 mg/mL. Subsequently, heating the coating at 100 °C for 10 minutes on a constant-temperature hotplate, and then spin-coating the coating with bathocuproine (BCP) at a speed of 5000 rpm to form a passivation layer, where the thickness of the PC₆₁BM layer is 60 nm, and the thickness of the BCP passivation layer is 6 nm.

Making a specimen of the resultant product, putting the specimen into a vacuum coater, and evaporating and depositing a 100-nm thick Ag electrode on the surface of the obtained electron transport layer under a vacuum condition of 5×10⁻⁴ Pa.

The perovskite battery prepared in Comparative Embodiment 1 is denoted as battery D1#, with a structure of ITO/PTAA/MAPbI₃/PC₆₁BM/BCP/Ag.

### Comparative Embodiment 2

Taking 20 ITO conductive glass sheets, each in a size of 2.0 cm × 2.0 cm. Laser-etching each of the glass sheets at 0.35 cm from the left and right ends of the sheet until 1 µm of the thickness is etched away so that the glass substrate is exposed. Subsequently, washing the surface of the glass sheet twice with acetone and isopropanol separately, and then immersing and sonicating the glass sheet in deionized water for 10 minutes. Drying the glass sheet by blowing nitrogen, and then cleaning the glass sheet in an ultraviolet ozone cleaner for 15 minutes.

Spin-coating the ITO conductive glass with a PTAA chlorobenzene solution at a speed of 5000 rpm, where the concentration of the solution is 2 mg/mL. Subsequently, heating the coating at 100 °C for 10 minutes on a constant-temperature hotplate to obtain an organic hole transport layer that is 20 nm thick.

Depositing a 4-nm thick PbI₂ layer onto the obtained organic hole transport layer through thermal evaporation. The vacuum degree of the thermal evaporation chamber is 5×10⁻⁵ Pa. During the thermal evaporation, the current is adjusted to deposit a 0.2-nm thickness at a speed of 0.1 Å/s first, and then the current is adjusted to deposit a 3.8-nm thickness at a speed of 0.5 Å/s.

Spin-coating the obtained inorganic hole transport layer with an MAPbI₃ N,N-dimethylformamide solution at a speed of 1000 rpm to 5000 rpm, where the concentration of the solution is 1.5 mol/L. Subsequently, heating the coating at 100 °C for 30 minutes on a constant-temperature hotplate, and then cooling it down to a room temperature to obtain a perovskite layer that is 680 nm thick.

Spin-coating the obtained perovskite layer with a PC₆₁BM chlorobenzene solution at a speed of 1000 rpm to 1500 rpm, where the concentration of the solution is 20 mg/mL. Subsequently, heating the coating at 100 °C for 10 minutes on a constant-temperature hotplate, and then spin-coating the coating with bathocuproine (BCP) at a speed of 5000 rpm to form a passivation layer, where the thickness of the PC₆₁BM layer is 60 nm, and the thickness of the BCP passivation layer is 6 nm.

Making a specimen of the resultant product, putting the specimen into a vacuum coater, and evaporating and depositing a 100-nm thick Ag electrode on the surface of the obtained electron transport layer under a vacuum condition of 5×10⁻⁴ Pa.

The perovskite battery prepared in Comparative Embodiment 2 is denoted as battery D2#, with a structure of ITO/PTAA/PbI₂/MAPbI₃/PC₆₁BM/BCP/Ag.

### Comparative Embodiment 3

Taking 20 ITO conductive glass sheets, each in a size of 2.0 cm × 2.0 cm. Laser-etching each of the glass sheets at 0.35 cm from the left and right ends of the sheet until 1 µm of the thickness is etched away so that the glass substrate is exposed. Subsequently, washing the surface of the glass sheet twice with acetone and isopropanol separately, and then immersing and sonicating the glass sheet in deionized water for 10 minutes. Drying the glass sheet by blowing nitrogen, and then cleaning the glass sheet in an ultraviolet ozone cleaner for 15 minutes.

Spin-coating the ITO conductive glass with a PTAA chlorobenzene solution at a speed of 5000 rpm, where the concentration of the solution is 2 mg/mL. Subsequently, heating the coating at 100 °C for 10 minutes on a constant-temperature hotplate to obtain an organic hole transport layer that is 20 nm thick.

Spin-coating the obtained organic hole transport layer with an glyceryl monostearate (GMS) methanol solution at a speed of 5000 rpm, where the concentration of the solution is 0.5 mg/ml. Subsequently, heating the coating at 110 °C for 10 minutes on a constant-temperature hotplate, so as to obtain an interface modification layer that is 4 nm thick.

Spin-coating the obtained interface modification layer with an MAPbI₃ N,N-dimethylformamide solution at a speed of 1000 rpm to 5000 rpm, where the concentration of the solution is 1.5 mol/L. Subsequently, heating the coating at 100 °C for 30 minutes on a constant-temperature hotplate, and then cooling it down to a room temperature to obtain a perovskite layer that is 680 nm thick.

Spin-coating the obtained perovskite layer with a PC₆₁BM chlorobenzene solution at a speed of 1000 rpm to 1500 rpm, where the concentration of the solution is 20 mg/mL. Subsequently, heating the coating at 100 °C for 10 minutes on a constant-temperature hotplate, and then spin-coating the coating with bathocuproine (BCP) at a speed of 5000 rpm to form a passivation layer, where the thickness of the PC₆₁BM layer is 60 nm, and the thickness of the BCP passivation layer is 6 nm.

Making a specimen of the resultant product, putting the specimen into a vacuum coater, and evaporating and depositing a 100-nm thick Ag electrode on the surface of the obtained electron transport layer under a vacuum condition of 5×10⁻⁴ Pa.

The perovskite battery prepared in Comparative Embodiment 3 is denoted as battery D3#, with a structure of ITO/PTAA/GMS/MAPbI₃/PC₆₁BM/BCP/Ag.

FIG. 2 shows a coating result of a perovskite precursor solution in Embodiments 1 to 5 and Comparative Embodiments 1 to 3. As shown in FIG. 2, the perovskite precursor solutions in Embodiments 1 to 5 can fully overlay the whole substrate, indicating a good effect of infiltration at the interface between the organic hole transport layer and the perovskite layer. The yield rate of the 20 perovskite batteries is 100%. By contrast, the perovskite precursor solution in Comparative Embodiment 1 overlays just a part of the surface of the substrate, and the yield rate of the perovskite batteries is much lower than 100%.

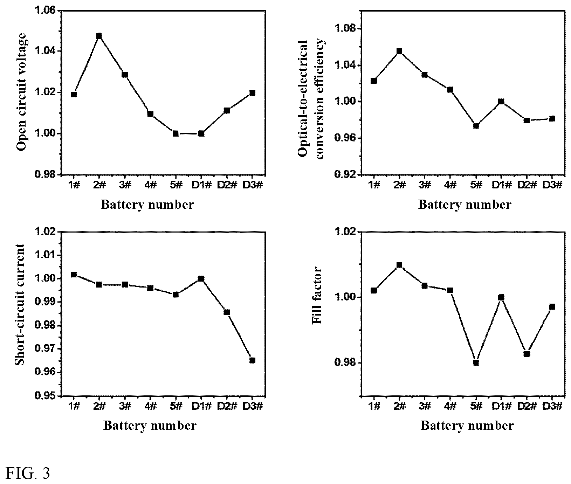

The perovskite batteries prepared in Embodiments 1 to 5 and Comparative Embodiments 1 to 3 are tested under a solar irradiation standard spectrum (solar spectrum of AM 1.5G, irradiance of 100 mW/cm²), and the test results are shown in FIG. 3. In FIG. 3, the abscissa represents the battery number, and the ordinate represents a ratio of each performance indicator value (open circuit voltage, optical-to-electrical conversion efficiency, short-circuit current, and fill factor) of the perovskite batteries prepared in Embodiments 1 to 5 and Comparative Embodiments 1 to 3 to the counterpart of the perovskite battery prepared in Comparative Embodiment 1.

As can be seen from FIG. 3, the addition of a relatively thin nickel oxide layer between the organic hole transport layer and the perovskite layer does not adversely affect the performance of the perovskite battery, but improves the efficiency of extraction and transport of hole carriers at the interface to some extent, reduces the recombination of electrons and holes at the interface, and in turn, the improves the open circuit voltage, fill factor value, and optical-to-electrical conversion efficiency of the perovskite battery. When the thickness of the nickel oxide layer is 4 nm, the performance of the perovskite battery is optimal.

When the thickness of the nickel oxide layer is 10 nm, the ratio of the thickness of the nickel oxide layer to the thickness of the PTAA layer is greater than 0.4, and the short-circuit current, fill factor value, and optical-to-electrical conversion efficiency of the perovskite battery all decline to different degrees. A possible reason is that the hole extraction capability of the nickel oxide is lower than that of the PTAA. When the ratio of the thickness of the nickel oxide layer to the thickness of the PTAA layer is greater than 0.4, the PTAA is hindered from extracting holes, thereby resulting in reduced efficiency of extracting hole carriers and severe recombination of carriers at the interface. In addition, the size of the perovskite grains grown on the nickel oxide layer is relatively small. The quality of the perovskite crystals grown in this case is not as high as the quality of the crystals grown directly on the surface of the PTAA, both bulk defects and interfacial defects of the perovskite crystals increase, and therefore, electrons and holes are prone to recombine at the interface.

When a relatively thin PbI₂ layer is added between the PTAA layer and the MAPbI₃ layer in Comparative Embodiment 2, as shown in FIG. 2, the MAPbI₃ N,N-dimethylformamide solution can overlay the entire substrate, indicating a good effect of infiltration at the interface between the PTAA layer and the MAPbI₃ layer. However, in contrast to Comparative Embodiment 1, the performance of the perovskite battery declines significantly. As shown in FIG. 3, the short-circuit current and the fill factor value decline significantly. A possible reason is that the sputtering process of the PbI₂ needs to be performed at a high temperature, thereby impairing the performance of the PTAA, resulting in damage to the interface and increase of the contact resistance, and in turn, decreasing the fill factor significantly. In addition, in the process of coating the PbI₂ layer with the MAPbI₃ N,N-dimethylformamide solution, a part of the PbI₂ is dissolved, resulting in a severe excess of the PbI₂ in the perovskite precursor solution. Consequently, the crystallization quality of the perovskite material is low, and the short-circuit current and the fill factor value of the perovskite battery decline significantly.

When a relatively thin GMS layer is added between the PTAA layer and the MAPbI₃ layer in Comparative Embodiment 3, as shown in FIG. 2, the MAPbI₃ N,N-dimethylformamide solution can overlay the entire substrate, indicating a good effect of infiltration at the interface between the PTAA layer and the MAPbI₃ layer. However, in contrast to Comparative Embodiment 1, the performance of the perovskite battery also declines significantly. As shown in FIG. 3, the short-circuit current declines significantly. A possible reason is that the GMS itself is not conductive. After the GMS layer is added between the PTAA layer and the MAPbI₃ layer, the overall resistance of the perovskite battery increases, resulting in a severe decline in the short-circuit current and a decline in the fill factor value.

What is described above is merely specific embodiments of this application, but is not intended to limit the protection scope of this application. Various equivalent modifications and replacements conceivable by any person skilled in the art without departing from the technical scope disclosed herein still fall within the protection scope of this application. Therefore, the protection scope of this application is subject to the protection scope of the claims.

## Claims

1. A perovskite battery, comprising:
a first electrode;
a second electrode;
a perovskite layer, located between the first electrode and the second electrode;
an organic hole transport layer, located between the first electrode and the perovskite layer; and
an inorganic hole transport layer, located between the organic hole transport layer and the perovskite layer,
wherein,
a thickness H₁ of the inorganic hole transport layer and a thickness H₂ of the organic hole transport layer satisfy H₁/H₂ ≤ 0.4, and optionally 0.1 ≤ H₁/H₂ ≤ 0.4; and
the inorganic hole transport layer comprises an inorganic hole transport material, and the inorganic hole transport material is selected from inorganic P-type semiconductor materials that are soluble in N,N-dimethylformamide under a room temperature at a solubility lower than 0.10 mg/mL.

2. The perovskite battery according to claim 1, wherein the thickness H₁ of the inorganic hole transport layer is less than or equal to 10 nm, and optionally, 2 nm ≤ H₁ ≤ 8 nm.

3. The perovskite battery according to claim 1 or 2, wherein the thickness H₂ of the organic hole transport layer is 10 nm to 30 nm.

4. The perovskite battery according to any one of claims 1 to 3, wherein H₁ + H₂ ≤ 30 nm.

5. The perovskite battery according to any one of claims 1 to 4, wherein the thickness H₁ of the inorganic hole transport layer, the thickness H₂ of the organic hole transport layer, and a thickness H₃ of the perovskite layer satisfy (H₁ + H₂)/H₃ ≤ 1/20, and optionally, 1/50 ≤ (H₁ + H₂)/H₃ ≤ 1/20.

6. The perovskite battery according to any one of claims 1 to 5, wherein the inorganic P-type semiconductor materials comprise at least one of a material represented by a structural formula MNₓ or a material obtained by doping same; in the structural formula, M is at least one of Cu, Ni, Mo, Co, Cr, Sn, Mn, W, or V, and optionally, M is at least one of Cu, Ni, or Mo; N is at least one of O, S, SCN, F, Cl, Br, or I, and optionally, N is at least one of O, SCN, or I; and 0 < x ≤ 3; and
optionally, the inorganic P-type semiconductor materials are at least one selected from nickel oxide, molybdenum oxide, cuprous iodide, cuprous oxide, cuprous thiocyanate, and a material obtained by doping any one thereof.

7. The perovskite battery according to any one of claims 1 to 6, wherein, a conduction band minimum of the inorganic P-type semiconductor materials is greater than or equal to -3.9 eV, and a valence band maximum falls between -5.4 eV and - 5.1 eV

8. The perovskite battery according to any one of claims 1 to 7, wherein the organic hole transport layer comprises an organic hole transport material, and the organic hole transport material is at least one selected from poly[bis(4-phenyl)(2,4,6-trimethylphenyl)amine], poly(3-hexylthiophene), triptycene-cored triphenylamine, 3,4-ethylenedioxythiophene-methoxytriphenylamine, N-(4-aniline)carbazole-spirobifluorene, poly(3,4-ethylenedioxythiophene):polystyrene sulfonic acid, polythiophene, a derivative of any one thereof, and a material obtained by doping any one thereof.

9. The perovskite battery according to any one of claims 1 to 8, wherein the perovskite layer comprises a perovskite material; and optionally, the perovskite material is at least one selected from an inorganic halide perovskite material, an organic halide perovskite material, and an organic-inorganic hybrid halide perovskite material.

10. The perovskite battery according to any one of claims 1 to 9, wherein
a material of the first electrode comprises a transparent metal conductive oxide, and optionally, the transparent metal conductive oxide comprises at least one of fluorine-doped tin oxide, indium-doped tin oxide, aluminum-doped zinc oxide, boron-doped zinc oxide, or indium-doped zinc oxide; and/or
a material of the second electrode comprises at least one of carbon, gold, silver, aluminum, copper, fluorine-doped tin oxide, indium-doped tin oxide, aluminum-doped zinc oxide, boron-doped zinc oxide, or indium-doped zinc oxide.

11. The perovskite battery according to any one of claims 1 to 10, wherein the perovskite battery further comprises an electron transport layer located between the perovskite layer and the second electrode.

12. A method for preparing a perovskite battery, comprising at least steps of: forming an organic hole transport layer on a first electrode, forming an inorganic hole transport layer on the organic hole transport layer, and forming a perovskite layer on the inorganic hole transport layer,
wherein,
a thickness H₁ of the inorganic hole transport layer and a thickness H₂ of the organic hole transport layer satisfy H₁/H₂ ≤ 0.4, and optionally 0.1 ≤ H₁/H₂ ≤ 0.4; and
the inorganic hole transport layer comprises an inorganic hole transport material, and the inorganic hole transport material is selected from inorganic P-type semiconductor materials that are soluble in N,N-dimethylformamide under a room temperature at a solubility lower than 0.10 mg/mL.

13. The method according to claim 12, wherein the thickness H₁ of the inorganic hole transport layer is less than or equal to 10 nm, and optionally, 2 nm ≤ H₁ ≤ 8 nm.

14. The method according to claim 12 or 13, wherein the thickness H₂ of the organic hole transport layer is 10 nm to 30 nm.

15. The method according to any one of claims 12 to 14, wherein H₁ + H₂ ≤ 30 nm.

16. The method according to any one of claims 12 to 15, wherein the thickness H₁ of the inorganic hole transport layer, the thickness H₂ of the organic hole transport layer, and a thickness H₃ of the perovskite layer satisfy (H₁ + H₂)/H₃ ≤ 1/20, and optionally, 1/50 ≤ (H₁ + H₂)/H₃ ≤ 1/20.

17. The method according to any one of claims 12 to 16, wherein the inorganic P-type semiconductor materials comprise at least one of a material represented by a structural formula MNₓ or a material obtained by doping same; in the structural formula, M is at least one of Cu, Ni, Mo, Co, Cr, Sn, Mn, W, or V, and optionally, M is at least one of Cu, Ni, or Mo; N is at least one of O, S, SCN, F, Cl, Br, or I, and optionally, N is at least one of O, SCN, or I; and 0 < x ≤ 3; and
optionally, the inorganic P-type semiconductor materials are at least one selected from nickel oxide, molybdenum oxide, cuprous iodide, cuprous oxide, cuprous thiocyanate, and a material obtained by doping any one thereof.

18. The method according to any one of claims 12 to 17, wherein, a conduction band minimum of the inorganic P-type semiconductor materials is greater than or equal to -3.9 eV, and a valence band maximum falls between -5.4 eV and -5.1 eV

19. A photovoltaic module, comprising the perovskite battery according to any one of claims 1 to 11 or a perovskite battery prepared by the method according to any one of claims 12 to 18.
